# EUROPEAN PATENT APPLICATION

(11) **EP 4 715 878 A1**
(43) Date of publication of application: **25.03.2026**
(21) Application number: 24818356.8
(22) Date of filing: 03.04.2024
(51) Int. Cl.: H01L 31/049, C09J 7/30, C09J 7/00, B29D 7/01

(54) **INSULATING LAYER, PREPARATION METHOD, BACK-CONTACT CONDUCTIVE INTEGRATED BACKPLANE AND PHOTOVOLTAIC MODULE**

(30) Priority: 08.06.2023 CN 202310679928; 08.06.2023 CN 202310682234
(71) Applicant: Longi Solar Technology (Taizhou) Co., Ltd., Taizhou, Jiangsu 225300 (CN)
(72) Inventor: KONG, Qingning, Taizhou, Jiangsu 225300 (CN); SI, Pengfei, Taizhou, Jiangsu 225300 (CN); WEN, Feng, Taizhou, Jiangsu 225300 (CN); CHEN, Jun, Taizhou, Jiangsu 225300 (CN); LI, Hua, Taizhou, Jiangsu 225300 (CN); MAO, Yi, Taizhou, Jiangsu 225300 (CN); ZAN, Tao, Taizhou, Jiangsu 225300 (CN)
(74) Representative: Pfenning, Meinig & Partner mbB
(86) International application number: PCT/CN2024/085876
(87) International publication number: WO 2024/250819

(57) **Abstract**

The present application discloses an insulating layer, a preparation method, a back-contact conductive integrated back sheet, and a photovoltaic module. The insulating layer includes a support layer, a first bonding layer, and a second bonding layer. The support layer includes a first surface and a second surface that are opposite. The first bonding layer is adhered to the first surface. The second bonding layer is adhered to the second surface. The first bonding layer and/or the second bonding layer includes a plurality of polyolefin films. At least one of the polyolefin films in contact with a bonded material includes 1 to 2 parts by weight of other polyolefin materials and 0.1 to 1 parts by weight of a polypropylene material. The other polyolefin materials are one or more of polyethylene, ethylene-propylene copolymer, ethylene-butene copolymer, ethylene-octene copolymer, ethylene-vinyl acetate copolymer, polyvinyl chloride, and vinyl chloride. In this way, the water vapor barrier effect is higher, the creep resistance is better, and the melting point temperature is higher, so that the probability of a connection failure can be reduced, and the stability and reliability of the insulating layer can be improved.

## Description

The present application claims priority to Chinese Patent Application No. 202310682234.8, filed with the China National Intellectual Property Administration on June 8, 2023 and entitled "INSULATING LAYER, BACK-CONTACT CONDUCTIVE INTEGRATED BACK SHEET, AND PHOTOVOLTAIC MODULE", and claims priority to Chinese Patent Application No. 202310679928.6, filed with the China National Intellectual Property Administration on June 8, 2023 and entitled "INSULATING LAYER, PREPARATION METHOD, BACK-CONTACT CONDUCTIVE INTEGRATED BACK SHEET, AND PHOTOVOLTAIC MODULE", which are incorporated herein by reference in their entireties.

### TECHNICAL FIELD

The present application relates to the field of photovoltaic module technologies, and in particular, to an insulating layer, a preparation method, a back-contact conductive integrated back sheet, and a photovoltaic module.

### BACKGROUND

In the related art, an encapsulant film material is used for an insulating layer of a photovoltaic module, and the insulating layer is bonded and fixed to a solar cell panel by a bonding layer.

However, during a reliability test process and in a daily use environment for a long time, the insulating layer may be contracted and deformed under external heat, leading to deformation of the bonding layer, or even causing a connection failure between the solar cell panel and a back-contact conductive back sheet.

### SUMMARY

The present application aims to at least resolve one of technical problems existing in the related art. Therefore, an objective of the present application is to provide an insulating layer, which has better compatibility between layers of the insulating layer, has a lower shrinkage rate and good thermal matching, and is not prone to shrinkage and deformation, so that the stability and reliability of an electrical connection between a solar cell panel and a back-contact conductive back sheet can be improved.

According to a first aspect, embodiments of the present application provide an insulating layer, including: a support layer, a first bonding layer, and a second bonding layer. The support layer includes a first surface and a second surface that are opposite. The first bonding layer is adhered to the first surface. The second bonding layer is adhered to the second surface. The first bonding layer and/or the second bonding layer includes a plurality of polyolefin films. At least one of the polyolefin films in contact with a bonded material includes 1 to 2 parts by weight of other polyolefin materials and 0.1 to 1 parts by weight of a polypropylene material. The other polyolefin materials are one or more of polyethylene, ethylene-propylene copolymer, ethylene-butene copolymer, ethylene-octene copolymer, ethylene-vinyl acetate copolymer, polyvinyl chloride, and vinyl chloride.

For the insulating layer according to the embodiments of the present application, the polyolefin films are selected as the first bonding layer and the second bonding layer, and contain a polypropylene material, so that the water vapor barrier effect is higher, the creep resistance is better, and the melting point temperature is higher, so that the probability of a connection failure can be reduced, and the stability and reliability of the insulating layer can be improved.

According to some embodiments of the present application, the plurality of polyolefin films include at least an outer polyolefin film away from the first surface or the second surface and an inner polyolefin film adhered to the first surface or the second surface, and the outer polyolefin film includes 1 to 2 parts by weight of the other polyolefin materials and 0.1 to 1 part by weight of the polypropylene material.

Further, the outer polyolefin film includes polyethylene, polypropylene, and ethylene-butene copolymer with a weight ratio ranging from 1:0.1:0 to 1:1:1.

Further, the inner polyolefin film includes 1 part by weight of the other polyolefin materials and 1 to 10 parts by weight of the polypropylene material.

Further, the inner polyolefin film includes polypropylene and ethylene-butene copolymer with a weight ratio ranging from 1:1 to 10:1.

In some embodiments, at least one intermediate polyolefin film is positioned between the outer polyolefin film and the inner polyolefin film, and weight ratios of components of the plurality of intermediate polyolefin films are the same or different.

Further, the intermediate polyolefin film includes 2 to 11 parts by weight of the other polyolefin materials and 1 to 10 parts by weight of the polypropylene material.

Further, the intermediate polyolefin film includes polyethylene, polypropylene, and ethylene-butene copolymer with a weight ratio ranging from 1:1:1 to 1:10:10.

Further, a thickness ratio of the outer polyolefin film, the intermediate polyolefin film, and the inner polyolefin film ranges from 1:1:1 to 1:10:1.

According to some embodiments of the present application, a thickness of the first bonding layer ranges from 10 µm to 100 µm, and a thickness of the second bonding layer ranges from 10 µm to 100 µm.

In some embodiments, a shrinkage rate of the support layer is less than 0.3%.

Further, the support layer is one or more of a polyester film, a polyimide film, a polycarbonate film, a polyurethane film, a polyvinyl chloride film, and a reinforced polypropylene film.

Further, the support layer is one of polyethylene terephthalate and polybutylene terephthalate.

Further, a thickness of the support layer ranges from 10 µm to 100 µm.

In some embodiments, the support layer is heat-treated in an oven with a length of 30 m to 100 m, a temperature of each section of the oven ranges from 120°C to 200°C, a film passing speed ranges from 1 m/min to 10 m/min, and a heating time is not less than 5 min, and where the shrinkage rate of the support layer is less than 0.3%.

Further, the support layer is heat-treated in an oven, a temperature of the oven ranges from 150°C to 170°C, and a heating time ranges from 3 min to 5 min.

According to some embodiments of the present application, an adhesive layer is further disposed between the support layer and the first bonding layer and another adhesive layer is positioned between the support layer and the second bonding layer, and a heat-resistant temperature of the adhesive layer is greater than 170°C.

Further, the adhesive layer includes polyurethane adhesive.

According to a second aspect, embodiments of the present application provide an insulating layer, including: a support layer, a first compatibility layer, a second compatibility layer, a first bonding layer, and a second bonding layer. The first compatibility layer is connected to one side of the support layer, and the second compatibility layer is connected to the other side of the support layer. The first bonding layer is connected to a side of the first compatibility layer that faces away from the support layer. The second bonding layer is connected to a side of the second compatibility layer that faces away from the support layer. The support layer includes a composite material. The composite material includes a resin and a filler. The filler includes at least one of carbon fiber, glass fiber, glass wool, talc powder, graphene, and mica sheets.

For the insulating layer according to the embodiments of the present application, the support layer is disposed, and the resin and the filler are blended to form a hybrid system. In this way, the dimensional stability and temperature resistance of the support layer can be improved, so that the shrinkage rate of the support layer is lower, and the probability of thermal deformation is reduced, thereby improving the stability and reliability of the insulating layer. In addition, the thermal matching of the support layer, the first compatibility layer, and the second compatibility layer is better, thereby mitigating the wrinkling of the insulating layer and reducing the probability of creep of the insulating layer.

According to some embodiments of the present application, the filler includes glass fiber and glass wool, and a weight ratio of the glass fiber to the glass wool ranges from 10:1 to 1:10.

In some embodiments, a mass fraction of the filler in the support layer ranges from 5% to 33%.

According to some embodiments of the present application, each of the first compatibility layer, the second compatibility layer, the first bonding layer, and the second bonding layer includes a polyolefin film, and the polyolefin film is made of at least one of polyethylene, polypropylene, ethylene-propylene copolymer, ethylene-butene copolymer, ethylene-octene copolymer, ethylene-vinyl acetate copolymer, polyvinyl chloride, and vinyl chloride.

Further, both the first bonding layer and the second bonding layer include a polymer blend, where the polymer blend includes polyethylene, polypropylene, and ethylene-butene copolymer, where a weight ratio of polyethylene to polypropylene to ethylene-butene copolymer ranges from 1:0.1:0 to 1:1:1.

Further, the first bonding layer and the second bonding layer use polyethylene as a primary constituent, blended with one or more other components selected from polypropylene, ethylene-propylene copolymer, ethylene-butene copolymer, ethylene-octene copolymer, ethylene-vinyl acetate copolymer, polyvinyl chloride, and vinyl chloride.

Further, weight ratios of components of the first bonding layer and the second bonding layer are the same or different.

In some embodiments, both the first compatibility layer and the second compatibility layer include polyethylene, polypropylene, and ethylene-butene copolymer with a weight ratio ranging from 1:1:1 to 1:10:10.

Further, the first compatibility layer and the second compatibility layer use polyethylene and polypropylene as primary constituents, blended with one or more other components selected from ethylene-propylene copolymer, ethylene-butene copolymer, ethylene-octene copolymer, ethylene-vinyl acetate copolymer, polyvinyl chloride, and vinyl chloride.

Further, weight ratios of components of the first compatibility layer and the second compatibility layer are the same or different.

According to some embodiments of the present application, a total thickness of the support layer, the first compatibility layer, the second compatibility layer, the first bonding layer, and the second bonding layer ranges from 20 µm to 200 µm.

Further, a thickness ratio of the first bonding layer, the first compatibility layer, the support layer, the second compatibility layer, and the second bonding layer ranges from 1:1:1:1:1 to 1:5:10:5:1.

According to a third aspect, embodiments of the present application provide a method for preparing an insulating layer, the preparation method being used for preparing the insulating layer in the foregoing embodiments, and the preparation method including:
performing blending, extracting, and pelletizing based on a weight ratio of material components of a first bonding layer, a first compatibility layer, a support layer, a second compatibility layer, and a second bonding layer; and
coextruding the five layers by cast film extrusion or blown film extrusion.

According to a fourth aspect, embodiments of the present application provide a back-contact conductive integrated back sheet, including the insulating layer in the foregoing embodiments

Further, a plurality of via holes are opened in the insulating layer, and the via holes are filled with a conductive material.

According to a fifth aspect, embodiments of the present application provide a photovoltaic module, including: a solar cell panel and the back-contact conductive integrated back sheet in the foregoing embodiments, where a circuit formed by a conductive material in via holes is interconnected with a circuit design of the solar cell panel.

The additional aspects and advantages of the present application are partially provided in the following description and partially become obvious from the following description or understood through the practice of the present application.

### BRIEF DESCRIPTION OF THE DRAWINGS

The foregoing and/or additional aspects and advantages of the present application will be apparent and easily comprehensible from the description of the embodiments with reference to the accompanying drawings.
FIG. 1 is a schematic diagram of an insulating layer according to an embodiment of the present application;
FIG. 2 is a schematic diagram of a first insulating layer or a second insulating layer according to an embodiment of the present application;
FIG. 3 is a schematic diagram of an insulating layer according to another embodiment of the present application;
FIG. 4 is a schematic diagram of a support layer of an insulating layer according to another embodiment of the present application;
FIG. 5 is a schematic diagram of a photovoltaic module according to an embodiment of the present application; and
FIG. 6 is a flowchart of a method for preparing an insulating layer according to another embodiment of the present application.

### Reference numerals:

insulating layer 100, back-contact conductive integrated back sheet 200, solar cell panel 300,
support layer 10, first compatibility layer 20, second compatibility layer 30, first bonding layer 40, second bonding layer 50, via hole 60, adhesive layer 70,
outer polyolefin film a, inner polyolefin film b, and intermediate polyolefin film c.

### DETAILED DESCRIPTION

The embodiments of the present application are described below in detail. Examples of the embodiments are shown in the accompanying drawings. The same or similar numerals represent the same or similar elements or elements having the same or similar functions throughout the specification. The embodiments described below with reference to the accompanying drawings are exemplary, and are only used to explain the present application but should not be construed as a limitation to the present application.

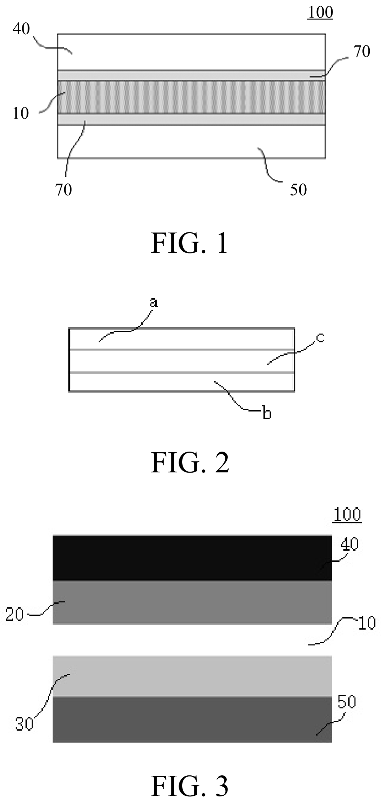

The following describes, with reference to FIG. 1 to FIG. 5, an insulating layer 100, a back-contact conductive integrated back sheet 200, and a photovoltaic module according to embodiments of the present application.

As shown in FIG. 1, the insulating layer 100 in the embodiments of the present application according to a first aspect includes a support layer 10, a first bonding layer 40, and a second bonding layer 50.

The support layer 10 includes a first surface and a second surface that are opposite. The first bonding layer 40 is adhered to the first surface, and the second bonding layer 50 is adhered to the second surface.

Specifically, the first bonding layer 40 and/or the second bonding layer 50 includes a plurality of polyolefin films, and at least one of the polyolefin films in contact with a bonded material includes 1 to 2 parts by weight of other polyolefin materials and 0.1 to 1 parts by weight of a polypropylene material. The other polyolefin materials are one or more of polyethylene, ethylene-propylene copolymer, ethylene-butene copolymer, ethylene-octene copolymer, ethylene-vinyl acetate copolymer, polyvinyl chloride, and vinyl chloride.

It should be noted that the first bonding layer 40 and/or the second bonding layer 50 includes the plurality of polyolefin films, and each polyolefin film may provide a different property, so that the bonding strength between the first bonding layer 40 and the support layer 10 and the bonding strength between the second bonding layer 50 and the support layer 10 are better. In addition, a composition ratio of at least one polyolefin film ranges from 1:0.1 to 2: 1, which can ensure effective bonding between the first bonding layer 40 and the bonded material and the second bonding layer 50 and the bonded material after hot pressing, and have good temperature resistance, thermal shock resistance, ultraviolet resistance, and high breakdown properties.

For the insulating layer 100 according to the embodiments of the present application, the polyolefin films are selected as the first bonding layer 40 and the second bonding layer 50, and contain a polypropylene material, so that the water vapor barrier effect is higher, the creep resistance is better, and the melting point temperature is higher, so that the probability of a connection failure can be reduced, and the stability and reliability of the insulating layer 100 can be improved.

It should be noted that the first bonding layer 40 and the second bonding layer 50 are in direct contact with the bonded material, and both the first bonding layer 40 and the second bonding layer 50 include at least one film structure with the foregoing composition ratio. The film structure has an appropriate amount of the polypropylene, so that the first bonding layer 40 and the second bonding layer 50 can be effectively bonded to a contact after thermal lamination, and have good characteristics of humidity and heat resistance, thermal shock resistance, ultraviolet resistance, and high breakdown strength.

As shown in FIG. 2, according to some embodiments of the present application, the plurality of polyolefin films include at least an outer polyolefin film a away from the first surface or the second surface and an inner polyolefin film b adhered to the first surface or the second surface, and the outer polyolefin film a includes 1 to 2 parts by weight of the other polyolefin materials and 0.1 to 1 part by weight of the polypropylene material.

That is, the layer of the first bonding layer 40 farthest away from the first surface is defined as the outer polyolefin film a, the layer of the second bonding layer 50 farthest away from the second surface is also defined as the outer polyolefin film a, and a weight ratio of at least the outer polyolefin film a satisfies the following: 1 to 2 parts by weight of the other polyolefin materials and 0.1 to 1 parts by weight of the polypropylene material, which can effectively improve the stability and reliability of a connection between the insulating layer 100 and the bonded material, prolong the service life, and reduce the probability of a connection failure.

In some embodiments, the outer polyolefin film a includes polyethylene, polypropylene, and ethylene-butene copolymer with a weight ratio ranging from 1:0.1:0 to 1:1:1.

In other words, in some embodiments, the weight ratio of polyethylene, polypropylene, and ethylene-butene copolymer satisfies 1:0.1:0, that is, 1 part by weight of the polyethylene is mixed with 0.1 part by weight of polypropylene. In some other embodiments, the weight ratio of polyethylene, polypropylene, and ethylene-butene copolymer satisfies 1:1:1, that is, 1 part by weight of polyethylene, 1 part by weight of polypropylene, and 1 part by weight of ethylene-butene copolymer are mixed, so that it can be ensured that the weight ratio of the outer polyolefin film a satisfies use, thereby improving the stability of a connection.

As shown in FIG. 2, the inner polyolefin film b includes 1 part by weight of the other polyolefin materials and 1 to 10 parts by weight of the polypropylene material.

Specifically, the inner polyolefin film b includes polypropylene and ethylene-butene copolymer with a weight ratio ranging from 1:1 to 10:1.

In this way, the content of the polypropylene component of the inner polyolefin film b is lower than the content of the polypropylene component of the outer polyolefin film a. Higher content of polypropylene can increase the melting point of the inner polyolefin film b, to ensure that the inner polyolefin film b does not melt when the outer polyolefin film a melts, so that it is ensured that creep does not occur in the insulating layer 100 in a later reliability test and in a daily use scenario. In addition, higher content of polypropylene can further reduce the water vapor transmission rate of the inner polyolefin film b, thereby improving the material reliability of the insulating layer 100.

Referring to FIG. 2, in some embodiments, at least one intermediate polyolefin film c is positioned between the outer polyolefin film a and the inner polyolefin film b, and weight ratios of components of the plurality of intermediate polyolefin films c are the same or different.

In this way, through the arrangement of the intermediate polyolefin film c, the intermediate polyolefin film c is formed as a transition layer, the intermediate polyolefin film c and the outer polyolefin film a have closer components, closer chemical structures, and closer chemical compatibility, and the intermediate polyolefin film c and the inner polyolefin film b have closer components, closer chemical structures, and closer chemical compatibility, so that thermal matching between the first bonding layer 40 and the second bonding layer 50 can be improved to mitigate wrinkling of the insulating layer 100, and the creep resistance of the insulating layer 100 can also be improved.

In some embodiments, the intermediate polyolefin film c includes 2 to 11 parts by weight of the other polyolefin materials and 1 to 10 parts by weight of the polypropylene material.

For example, the intermediate polyolefin film c includes polyethylene, polypropylene, and ethylene-butene copolymer with a weight ratio ranging from 1:1:1 to 1:10:10.

In this way, the content of the polypropylene component of the intermediate polyolefin film c is lower than the content of the polypropylene component of the outer polyolefin film a. Higher content of polypropylene can increase the melting point of the intermediate polyolefin film c, to ensure that the intermediate polyolefin film c does not melt when the outer polyolefin film a melts, so that it is ensured that creep does not occur in the insulating layer 100 in a later reliability test and in a daily use scenario. In addition, higher content of polypropylene can further reduce the water vapor transmission rate of the intermediate polyolefin film c, thereby improving the material reliability of the insulating layer 100.

As shown in FIG. 1 and FIG. 2, a thickness ratio of the outer polyolefin film a, the intermediate polyolefin film c, and the inner polyolefin film b ranges from 1:1:1 to 1:10:1, and each of the first bonding layer 40 and the second bonding layer 50 has a thickness of 10 µm to 100 µm, so that each of the first bonding layer 40 and the second bonding layer 50 has a more reasonable thickness, thereby ensuring the stability of bonding, and the thickness of the insulating layer 100 can be reduced while effectively resisting creep, wrinkling, and melting.

In some embodiments, a shrinkage rate of the support layer 10 is less than 0.3%, to reduce shrinkage and deformation of the support layer 10, so that the whole insulating layer 100 is subjected to less deformation in a later reliability test process and in a daily use scenario, so that an electrical connection failure between a back-contact conductive back sheet and the solar cell panel 300 can be avoided, thereby improving the use reliability and safety of the photovoltaic module.

It should be noted that the polyethylene includes, but is not limited to, LDPE/LLDPE/HDPE/MDPE/UHMWPE, and the polypropylene includes, but is not limited to, PPH/PPB/PPR.

Further, a thickness of the support layer 10 ranges from 10 µm to 100 µm, and the support layer 10 is one or more of a polyester film, a polyimide film, a polycarbonate film, a polyurethane film, a polyvinyl chloride film, and a reinforced polypropylene film.

That is, the polyester film is used as the support layer 10. In some embodiments, the polyester film is one of polyethylene terephthalate and polybutylene terephthalate. The polyester film includes, but is not limited to, a biaxially oriented polyester and a uniaxially oriented polyester, and is a polyethylene terephthalate film in some embodiments. The support layer 10 is heat-treated in an oven with a length of 30 m to 100 m, a temperature of each section of the oven ranges from 120°C to 200°C, a film passing speed ranges from 1 m/min to 10 m/min, and a heating time is not less than 5 min, and where the shrinkage rate of the support layer 10 is less than 0.3%.

It should be noted that the foregoing heat treatment process is an optional heat treatment method for processing the support layer 10 in batches at a factory. However, in a laboratory environment, when the support layer 10 is processed in small batches, the support layer 10 is heat-treated in an oven, a temperature of the oven ranges from 150°C to 170°C, and a heating time ranges from 3 min to 5 min, so that the shrinkage rate of the support layer 10 can be less than 0.3%.

According to some embodiments of the present application, an adhesive layer 70 is further disposed between the support layer 10 and the first bonding layer 40 and another adhesive layer 70 is positioned between the support layer 10 and the second bonding layer 50, and a heat-resistant temperature of the adhesive layer 70 is greater than 170°C, to satisfy an actual use environment of the insulating layer 100.

The adhesive layer 70 may be specifically one of acrylic adhesive with a cycloaromatic structure, polyurethane adhesive, polyvinyl acetate adhesive, epoxy resin adhesive, natural adhesive, hot-melt adhesive, inorganic adhesive, and the like, and is polyurethane adhesive including a main polyurethane adhesive base and a curing agent in some embodiments.

In this way, through the adhesive layer 70, the stability and reliability of connections between the first bonding layer 40 and the support layer 10 and between the second bonding layer 50 and the support layer 10 are improved, thermal matching is improved, shrinkage of the support layer 10 or creep of the bonding layer is avoided, and the service life of the insulating layer 100 is improved.

**Table 1: Table of comparison between the present application and the related art**

| Solution | Material of the insulating layer 100 | Shrinkage rate/% | Aging resistance time/h | Power attenuation |
|---|---|---|---|---|
| 1 | The support layer 10 is common PET, and the bonding layer is a 50-µm EVA adhesive film. | 2.70 | 12 | > 5% |
| 2 | The support layer 10 is common PET, and the bonding layer is a 50-µm PE film. | 1.14 | 12 | > 5% |
| 3 | The support layer 10 is PET in this patent, and the bonding layer is a 50-µm PE film. | 0.35 | 24 | 4% |
| 4 | The support layer 10 is common PET, and the bonding layer is a 50-µm polyolefin film in this patent. | 0.76 | 12 | > 5% |
| 5 | The support layer 10 is PET in this patent, and the bonding layer is a 50-µm polyolefin film in this patent. | 0.21 | 60 | 0.9% |
| Notes | Accelerated aging test under environmental simulation with a humidity of 100% and a temperature of 121°C within a closed space. | | | |

It can be known from the foregoing table that the shrinkage rate, the aging resistance time, and the power attenuation of the insulating layer 100 in this embodiment of the present application are obviously less than those in the related art. However, the shrinkage rate of the insulating layer 100 can be effectively reduced only by using the support layer 10 of the present application or by using the bonding layer of the present application. The aging resistance can also be prolonged to some extent by using only the support layer 10 of the present application. The use of the support layer 10 and the bonding layer of the present application can effectively reduce the shrinkage rate, improve the aging resistance, and mitigate the power attenuation.

**Table 2: Table of comparison between water vapor transmission rates of films of different materials**

| Material (25-µm thickness) | Water vapor transmission rate |
|---|---|
| BOPP film | 5 g/m²·24 hr |
| LDPE film | 20 g/m²·24 hr |
| HDPE film | 13 g/m²·24 hr |
| First bonding layer or second bonding layer of the present application | 3.65 g/m²·24 hr |

It can be known from the foregoing table that both the first bonding layer 40 and the second bonding layer 50 of the present application are constructed as multilayer film structures, and both the inner polyolefin film b and the intermediate polyolefin film c have lower water vapor transmission rates, so that the water vapor barrier effect of the first bonding layer 40 and the second bonding layer 50 can be improved.

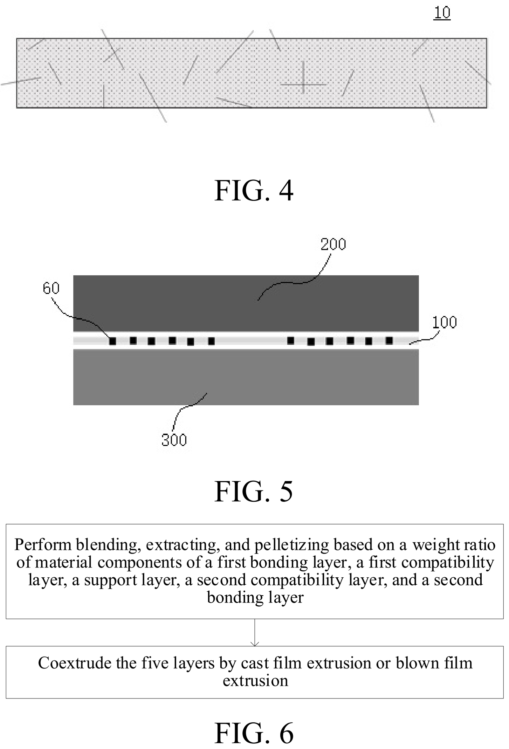

As shown in FIG. 3 and FIG. 4, the insulating layer 100 in the embodiments of the present application according to a second aspect includes a support layer 10, a first compatibility layer 20, a second compatibility layer 30, a first bonding layer 40, and a second bonding layer 50. The first compatibility layer 20 is connected to one side of the support layer 10, and the second compatibility layer 30 is connected to the other side of the support layer 10. The first bonding layer 40 is connected to a side of the first compatibility layer 20 that faces away from the support layer 10. The second bonding layer 50 is connected to a side of the second compatibility layer 30 that faces away from the support layer 10.

Specifically, the insulating layer 100 is constructed as a five-layer structure. The insulating layer 100 is an intermediate layer. Two surfaces of the insulating layer 100 that are opposite in an interposition direction of the five-layer structure are defined as a first surface and a second surface. The first surface is connected to the first compatibility layer 20, and the second surface is connected to the second compatibility layer 30. A surface of the first compatibility layer 20 that is away from the support layer 10 is connected to the first bonding layer 40, and a surface of the second compatibility layer 30 that is away from the support layer 10 is connected to the second bonding layer 50.

Referring to FIG. 4, the support layer 10 includes a resin and a filler, and the filler includes at least one of carbon fiber, glass fiber, glass wool, talc powder, graphene, and mica sheets.

It should be noted that the filler and the resin may be formed into a "hybrid system". That is, after the resin and the filler are blended, the filler may be uniformly filled in gaps of the resin, and may be uniformly dispersed in the resin to form the hybrid system, thereby improving the dimensional stability and the temperature resistance of the support layer 10. In addition, the surface roughness of the support layer 10 may be increased. The rough surface can improve the inter-layer bonding effect between the support layer 10 and the first compatibility layer 20 and between the support layer 10 and the second compatibility layer 30 to form strong interfacial bonding, and can improve the thermal matching between the support layer 10 and the first compatibility layer 20 and between the support layer 10 and the second compatibility layer 30.

For the insulating layer 100 according to the embodiments of the present application, the support layer 10 is disposed, and the resin and the filler are blended to form a hybrid system. In this way, the dimensional stability and temperature resistance of the support layer 10 can be improved, so that the shrinkage rate of the support layer 10 is lower, and the probability of thermal deformation is reduced, thereby improving the stability and reliability of the insulating layer 100. In addition, the thermal matching of the support layer 10, the first compatibility layer 20, and the second compatibility layer 30 is better, thereby mitigating the wrinkling of the insulating layer 100 and reducing the probability of creep of the insulating layer 100.

In some embodiments, the resin includes a polypropylene resin, which can further improve the melting point of the support layer 10 and lower the water vapor transmission rate of the support layer 10, thereby improving the creep resistance of the support layer 10, and improving the structural stability and reliability of the support layer 10.

As shown in FIG. 4, according to some embodiments of the present application, the filler includes glass fiber and glass wool, and a weight ratio of the glass fiber to the glass wool ranges from 10:1 to 1:10.

That is, in some embodiments, glass fiber and glass wool are selected for the filler. The glass fiber is surface-treated, and the glass wool can be uniformly filled in gaps of the resin to form a hybrid system. The glass fiber can improve the roughness of the first surface and the second surface of the support layer 10. In addition, the glass fiber that projects out of the first surface and the second surface can penetrate into the first compatibility layer 20 and the second compatibility layer 30 to form strong interfacial bonding. In this way, the shrinkage rate of the support layer 10 is less than 0.3%, and thermal deformation of the insulating layer 100 is effectively reduced, thereby reducing the probability that a failure occurs in the insulating layer 100.

It should be noted that a mixing ratio of mixing the glass fiber and the glass wool for the filler may be that ten parts by weight of the glass fiber is mixed with one part by weight of the glass wool, or ten parts by weight of glass wool may be mixed with one part by weight of glass fiber, provided that a specific mixing weight ratio satisfies the foregoing ratio relationship, a filling effect is better, and the structural strength and structural stability of the support layer 10 are higher.

In some embodiments, a mass fraction of the filler in the support layer 10 ranges from 5% to 33%.

It should be noted that the resin is a polypropylene layer, and a mass fraction of resin in the corresponding support layer 10 ranges from 67% to 95%. When the content of polypropylene in the support layer 10 is higher, the support layer 10 can have better high-temperature resistance, thereby ensuring that the support layer 10 does not melt during a later reliability test, and have a lower water vapor transmission rate, so that the insulating layer 100 has higher reliability.

It should be noted that the mechanical strength, the thermal property, and the dimensional stability of the support layer 10 in this embodiment of the present application can reach the level of a polyester material, and higher content of the polypropylene component in the polyolefin film indicates a higher melting point and a lower water vapor transmission rate.

**Table 3: Table of comparison between water vapor transmission rates of films of different materials**

| Material (25-µm thickness) | Water vapor transmission rate |
|---|---|
| BOPP film | 5 g/m²·24 hr |
| LDPE film | 20 g/m²·24 hr |
| HDPE film | 13 g/m²·24 hr |

It can be known from the foregoing table that the support layer 10 of the present application uses a polypropylene resin, and gap regions are filled with glass fiber or another fiber material, so that the support layer 10 has a lower water vapor transmission rate and a better water vapor barrier effect compared with an existing film.

According to some embodiments of the present application, each of the first compatibility layer 20, the second compatibility layer 30, the first bonding layer 40, and the second bonding layer 50 includes a polyolefin film.

Therefore, on one hand, each of the first compatibility layer 20, the second compatibility layer 30, the first bonding layer 40, and the second bonding layer 50 has closer material components, and includes a polyolefin film having close thermal matching, chemical compatibility, and molecular structures, so that wrinkling of the insulating layer 100 can be suppressed, and the stability and reliability of the insulating layer 100 can be improved.

It should be noted that the polyolefin film is made of at least one of polyethylene, polypropylene, ethylene-propylene copolymer, ethylene-butene copolymer, ethylene-octene copolymer, ethylene-vinyl acetate copolymer, polyvinyl chloride, and vinyl chloride.

Further, both the first bonding layer 40 and the second bonding layer 50 include a polymer blend, where the polymer blend includes polyethylene, polypropylene, and ethylene-butene copolymer, where a weight ratio of polyethylene to polypropylene to ethylene-butene copolymer ranges from 1:0.1:0 to 1:1:1.

The first bonding layer 40 and the second bonding layer 50 are directly in contact with a bonded material, may be effectively bonded to a contact after hot pressing, and need to have characteristics of good temperature resistance, thermal shock resistance, ultraviolet resistance, and high breakdown strength.

In some embodiments, the first bonding layer 40 and the second bonding layer 50 use polyethylene as a primary constituent, blended with one or more other components selected from polypropylene, ethylene-propylene copolymer, ethylene-butene copolymer, ethylene-octene copolymer, ethylene-vinyl acetate copolymer, polyvinyl chloride, and vinyl chloride.

In this way, the first bonding layer 40 and the second bonding layer 50 use polyethylene that has higher bonding stability and is easy to melt as a primary material, so that the effective bonding between the first bonding layer 40 and the contact and the second bonding layer 50 and the contact can be improved, thereby improving the stability and reliability of bonding.

Both the first bonding layer 40 and the second bonding layer 50 of the present application include a polymer blend, where the polymer blend includes polyethylene, polypropylene, and ethylene-butene copolymer, where a weight ratio of polyethylene to polypropylene to ethylene-butene copolymer ranges from 1:0.1:0 to 1:1:1. For example, 1 part by weight of the polyethylene is blended with 0.1 part by weight of the polypropylene. Alternatively, 1 part by weight of the polyethylene, 1 part by weight of the polypropylene, and 1 part by weight of the ethylene-butene copolymer are blended.

In this way, content of the polypropylene in the first bonding layer 40 and the second bonding layer 50 is less than that in the support layer 10. During a hot-pressing process, the first bonding layer 40 and the second bonding layer 50 melt to complete bonding, but the support layer 10 does not melt, so that creep in the insulating layer 100 can be suppressed in a reliability test process. In addition, when the content of the polypropylene is lower, the first bonding layer 40 and the second bonding layer 50 have good temperature resistance, thermal shock resistance, ultraviolet resistance, and high breakdown strength.

In some embodiments, both the first compatibility layer 20 and the second compatibility layer 30 include polyethylene, polypropylene, and ethylene-butene copolymer with a weight ratio ranging from 1:1:1 to 1:10:10.

In this way, on one hand, content of polypropylene in the first compatibility layer 20 and the second compatibility layer 30 is higher than that in the first bonding layer 40 and the second bonding layer 50, and it can also be ensured that the first compatibility layer 20 and the second compatibility layer 30 do not melt in a hot-pressing process. On the other hand, materials of the first bonding layer 40 and the second bonding layer 50 both belong to the main category of polyolefins, and a difference between the components of the first compatibility layer 20 and the second compatibility layer 30 and the components of the first bonding layer 40 and the second bonding layer 50 lies only in the content of the polypropylene, and a proportion range of the polypropylene in the first compatibility layer 20 and the second compatibility layer 30 is large. Both trim waste and scrap materials generated in a production process can be recycled, and are added and applied to the first compatibility layer 20 and the second compatibility layer 30 for recycling and reuse, thereby reducing material costs.

In some embodiments, the first compatibility layer 20 and the second compatibility layer 30 use polyethylene and polypropylene as primary constituents, blended with one or more other components selected from ethylene-propylene copolymer, ethylene-butene copolymer, ethylene-octene copolymer, ethylene-vinyl acetate copolymer, polyvinyl chloride, and vinyl chloride.

In this way, the first compatibility layer 20 and the second compatibility layer 30 use polyethylene and polypropylene as primary constituents, and have high content of the polypropylene, to increase the melting points of the first compatibility layer 20 and the second compatibility layer 30, so that when the first bonding layer 40 and the second bonding layer 50 melt under heat, the first compatibility layer 20 and the second compatibility layer 30 melt, thereby improving the reliability and the stability of the first compatibility layer 20 and the second compatibility layer 30, reducing the probabilities of creep and wrinkling in the first compatibility layer 20 and the second compatibility layer 30, and improving the stability and reliability of the insulating layer 100.

Further, the weight ratios of the components of the first compatibility layer 20 and the second compatibility layer 30 are the same or different, and the weight ratios of the components of the first bonding layer 40 and the second bonding layer 50 are the same or different. Such weight ratios can be properly adjusted according to a production requirement and a use requirement. When the components of the first compatibility layer 20 and the second compatibility layer 30 are the same and the weight ratios of the components of the first bonding layer 40 and the second bonding layer 50 are the same, production efficiency can be improved. When the weight ratios of the components of the first bonding layer 40 and the second bonding layer 50 are different and the weight ratios of the components of the first compatibility layer 20 and the second compatibility layer 30 are different, different performance may be correspondingly matched.

It should be noted that the polyethylene in this embodiment of the present application includes, but is not limited to, LDPE, LLDPE, HDPE, MDPE, and UHMWPE, and the polypropylene includes, but is not limited to, PPH, PPB, and PPR.

According to some embodiments of the present application, a total thickness of the support layer 10, the first compatibility layer 20, the second compatibility layer 30, the first bonding layer 40, and the second bonding layer 50 ranges from 20 µm to 200 µm, so that the thickness of the insulating layer 100 is more reasonable, and the weight ratios satisfy a use requirement.

As shown in FIG. 3, a thickness ratio of the first bonding layer 40, the first compatibility layer 20, the support layer 10, the second compatibility layer 30, and the second bonding layer 50 ranges from 1:1:1:1:1 to 1:5:10:5:1. The support layer 10 has a large thickness, and the properties of the support layer 10 enable better creep resistance and wrinkling resistance of the whole insulating layer 100, thereby improving the service stability and reliability of the insulating layer 100. The first bonding layer 40 and the second bonding layer 50 have small thicknesses, and the thickness of the insulating layer 100 can be further reduced while ensuring the stability of bonding.

As shown in FIG. 6, according to a second aspect, embodiments of the present application provide a method for preparing an insulating layer 100. The preparation method is suitable for preparing the insulating layer 100 in the foregoing embodiments. The preparation method includes:
performing blending, extracting, and pelletizing based on a weight ratio of material components of a first bonding layer 40, a first compatibility layer 20, a support layer 10, a second compatibility layer 30, and a second bonding layer 50; and
coextruding the five layers by cast film extrusion or blown film extrusion.

Both the first bonding layer 40 and the second bonding layer 50 include a polymer blend, where the polymer blend includes polyethylene, polypropylene, and ethylene-butene copolymer, where a weight ratio of polyethylene to polypropylene to ethylene-butene copolymer ranges from 1:0.1:0 to 1:1:1. Both the first compatibility layer 20 and the second compatibility layer 30 include polyethylene, polypropylene, and ethylene-butene copolymer with a weight ratio ranging from 1:1:1 to 1:10:10.

According to the method for preparing an insulating layer 100 in this embodiment of the present application, the first bonding layer 40, the second bonding layer 50, the first compatibility layer 20, and the second compatibility layer 30 have close components, and have closer chemical compatibility, molecular structures, and the like, so that the thermal matching of the insulating layer 100 is better, the use stability is higher, and the probabilities of creep and wrinkling are lower. In addition, trim waste and scrap materials can be recycled and then processed into the first compatibility layer 20 or the second compatibility layer 30, so that material costs can also be reduced.

According to a third aspect, embodiments of the present application a back-contact conductive integrated back sheet 200, including: the insulating layer 100 in the foregoing embodiments. A plurality of via holes 60 are opened in the insulating layer 100, and the via holes 60 are filled with a conductive material.

Specifically, the back-contact conductive integrated back sheet 200 includes a substrate, a mounting layer, and the insulating layer 100. An encapsulation layer may be further disposed on the insulating layer 100. The arrangement of the conductive material embedded in the insulating layer 100 should be consistent with the circuit design of the photovoltaic module. In addition, the conductive material may be a metal foil, which includes, for example, one or more of an aluminum foil, a tin foil, a copper foil, a nickel foil, a silver foil, a gold foil, and a tinned copper foil. The insulating layer 100 is used for electrically isolating the conductive material from a solar cell sheet in the solar cell panel 300. A wire material filled in the via holes 60 may implement an electrical connection between the solar cell panel 300 and the back-contact conductive integrated back sheet 200.

According to the back-contact conductive integrated back sheet 200 in this embodiment of the present application, the foregoing insulating layer 100 is used, so that the service life, the operating stability, and the reliability of the back-contact conductive integrated back sheet 200 can be prolonged.

According to a fourth aspect, embodiments of the present application provide a photovoltaic module, including: a solar cell panel 300 and the back-contact conductive integrated back sheet 200 in the foregoing embodiments. A circuit formed by a conductive material in via holes 60 is interconnected with a circuit design of the solar cell panel 300, and has a technical effect consistent with that of the back-contact conductive integrated back sheet 200. Details are not described herein again.

In the description of the present application, it needs to be understood that orientation or location relationships indicated by terms "center", "longitudinal", "transverse", "length", "width", "thickness", "up", "down", "front", "rear", "left", "right", "vertical", "horizontal", "top", "bottom", "inside", "outside", "clockwise", "counterclockwise", "axial", "radial", and "circumferential" are based on orientation or location relationships shown in the accompanying drawings, and are only used to facilitate description of the present application and simplify description, but are not used to indicate or imply that the apparatuses or elements must have specific orientations or are constructed and operated by using specific orientations, and therefore, cannot be understood as a limit to the present application.

In the description of the present application, "the first feature" and "the second feature" may include one or more such features.

In the description of the present application, "a plurality of" herein means "two or more".

In the description of the present application, the expression of the first feature being "above" or "below" the second feature may comprise the case that the first feature is in direct contact with the second feature, and may also comprise the case that the first and second features are not in direct contact but are contacted via another feature therebetween.

In the description of the present application, the first feature being "over", "above" or "on" the second feature comprises the case that the first feature is directly or obliquely above the second feature, or merely indicates that the first feature is at a higher level than the second feature.

In the descriptions of this specification, descriptions using reference terms "an embodiment", "some embodiments", "an exemplary embodiment", "an example", "a specific example", or "some examples" mean that specific characteristics, structures, materials, or features described with reference to the embodiment or example are included in at least one embodiment or example of the present application. In the specification, the schematic descriptions of the foregoing terms do not necessarily involve the same embodiments or examples. In addition, the described specific features, structures, materials or characteristics may be combined in an appropriate manner in any one or more embodiments or examples.

Although the embodiments of the present application have been shown and described, a person of ordinary skill in the art should understand that various changes, modifications, replacements and variations may be made to the embodiments without departing from the principles and spirit of the present application, and the scope of the present application is as defined by the appended claims and their equivalents.

## Claims

1. An insulating layer, comprising:
a support layer (10), the support layer (10) comprising a first surface and a second surface that are opposite;
a first bonding layer (40), the first bonding layer (40) being adhered to the first surface; and
a second bonding layer (50), the second bonding layer (50) being adhered to the second surface, wherein
the first bonding layer (40) and/or the second bonding layer (50) comprises a plurality of polyolefin films, and at least one of the polyolefin films in contact with a bonded material comprises 1 to 2 parts by weight of other polyolefin materials and 0.1 to 1 parts by weight of a polypropylene material; and the other polyolefin materials are one or more of polyethylene, ethylene-propylene copolymer, ethylene-butene copolymer, ethylene-octene copolymer, ethylene-vinyl acetate copolymer, polyvinyl chloride, or vinyl chloride.

2. The insulating layer according to claim 1, wherein the plurality of polyolefin films comprise at least an outer polyolefin film (a) away from the first surface or the second surface and an inner polyolefin film (b) adhered to the first surface or the second surface, and the outer polyolefin film (a) comprises 1 to 2 parts by weight of the other polyolefin materials and 0.1 to 1 part by weight of the polypropylene material.

3. The insulating layer according to claim 2, wherein the outer polyolefin film (a) comprises polyethylene, polypropylene, and ethylene-butene copolymer with a weight ratio ranging from1:0.1:0 to 1:1:1.

4. The insulating layer according to claim 2, wherein the inner polyolefin film (b) comprises 1 part by weight of the other polyolefin materials and 1 to 10 parts by weight of the polypropylene material.

5. The insulating layer according to claim 4, wherein the inner polyolefin film (b) comprises polypropylene and ethylene-butene copolymer with a weight ratio ranging from 1:1 to 10:1.

6. The insulating layer according to claim 2, wherein at least one intermediate polyolefin film (c) is positioned between the outer polyolefin film (a) and the inner polyolefin film (b), and weight ratios of components of the plurality of intermediate polyolefin films (c) are the same or different.

7. The insulating layer according to claim 6, wherein the intermediate polyolefin film (c) comprises 2 to 11 parts by weight of the other polyolefin materials and 1 to 10 parts by weight of the polypropylene material.

8. The insulating layer according to claim 7, wherein the intermediate polyolefin film (c) comprises polyethylene, polypropylene, and ethylene-butene copolymer with a weight ratio ranging from 1:1:1 to 1:10:10.

9. The insulating layer according to claim 6, wherein a thickness ratio of the outer polyolefin film (a), the intermediate polyolefin film (c), and the inner polyolefin film (b) ranges from 1:1:1 to 1:10:1.

10. The insulating layer according to any one of claims 1 to 9, wherein a thickness of the first bonding layer (40) ranges from 10 µm to 100 µm, and a thickness of the second bonding layer (50) ranges from 10 µm to 100 µm.

11. The insulating layer according to claim 1, wherein a shrinkage rate of the support layer (10) is less than 0.3%.

12. The insulating layer according to claim 11, wherein the support layer (10) is one or more of a polyester film, a polyimide film, a polycarbonate film, a polyurethane film, a polyvinyl chloride film, and a reinforced polypropylene film.

13. The insulating layer according to claim 12, wherein the support layer (10) is one of polyethylene terephthalate and polybutylene terephthalate.

14. The insulating layer according to claim 11, wherein a thickness of the support layer (10) ranges from 10 µm to 100 µm.

15. The insulating layer according to any one of claims 11 to 14, wherein the support layer (10) is heat-treated in an oven with a length of 30 m to 100 m, a temperature of each section of the oven ranges from 120°C to 200°C, a film passing speed ranges from 1 m/min to 10 m/min, and a heating time is not less than 5 min, and wherein the shrinkage rate of the support layer (10) is less than 0.3%.

16. The insulating layer according to any one of claims 11 to 14, wherein the support layer (10) is heat-treated in an oven, a temperature of the oven ranges from 150°C to 170°C, and a heating time ranges from 3 min to 5 min.

17. The insulating layer according to claim 1, wherein an adhesive layer (70) is positioned between the support layer (10) and the first bonding layer (40) and another adhesive layer (70) is positioned between the support layer (10) and the second bonding layer (50), and a heat-resistant temperature of the adhesive layer (70) is greater than 170°C.

18. The insulating layer according to claim 17, wherein the adhesive layer (70) comprises a polyurethane adhesive.

19. An insulating layer, comprising:
a support layer (10);
a first compatibility layer (20) and a second compatibility layer (30), the first compatibility layer (20) being connected to one side of the support layer (10), and the second compatibility layer (30) being connected to the other side of the support layer (10); and
a first bonding layer (40) and a second bonding layer (50), the first bonding layer (40) being connected to a side of the first compatibility layer (20) that faces away from the support layer (10), and the second bonding layer (50) being connected to a side of the second compatibility layer (30) that faces away from the support layer (10), wherein
the support layer (10) comprises a composite material, the composite material comprises a resin and a filler, and the filler comprises at least one of carbon fiber, glass fiber, glass wool, talc powder, graphene, and mica sheets.

20. The insulating layer according to claim 19, wherein the resin comprises a polypropylene resin.

21. The insulating layer according to claim 19, wherein the filler comprises glass fiber and glass wool, and a weight ratio of the glass fiber to the glass wool ranges from 10:1 to 1:10.

22. The insulating layer according to claim 19, wherein a mass fraction of the filler in the support layer (10) ranges from 5% to 33%.

23. The insulating layer according to claim 19, wherein each of the first compatibility layer (20), the second compatibility layer (30), the first bonding layer (40), and the second bonding layer (50) comprises a polyolefin film, and the polyolefin film is made of at least one of polyethylene, polypropylene, ethylene-propylene copolymer, ethylene-butene copolymer, ethylene-octene copolymer, ethylene-vinyl acetate copolymer, polyvinyl chloride, and vinyl chloride.

24. The insulating layer according to claim 23, wherein both the first bonding layer (40) and the second bonding layer (50) comprise a polymer blend, wherein the polymer blend comprises polyethylene, polypropylene, and ethylene-butene copolymer, wherein a weight ratio of polyethylene to polypropylene to ethylene-butene copolymer ranges from 1:0.1:0 to 1:1:1.

25. The insulating layer according to claim 23, wherein the first bonding layer (40) and the second bonding layer (50) use polyethylene as a primary constituent, blended with one or more other components selected from polypropylene, ethylene-propylene copolymer, ethylene-butene copolymer, ethylene-octene copolymer, ethylene-vinyl acetate copolymer, polyvinyl chloride, and vinyl chloride.

26. The insulating layer according to claim 25, wherein weight ratios of components of the first bonding layer (40) and the second bonding layer (50) are the same or different.

27. The insulating layer according to claim 23, wherein both the first compatibility layer (20) and the second compatibility layer (30) comprise a polymer blend, wherein the polymer blend comprises polyethylene, polypropylene, and ethylene-butene copolymer, wherein a weight ratio of polyethylene to polypropylene to ethylene-butene copolymer ranges from 1:1:1 to 1:10:10.

28. The insulating layer according to claim 23, wherein the first compatibility layer (20) and the second compatibility layer (30) use polyethylene and polypropylene as primary constituents, blended with one or more other components selected from ethylene-propylene copolymer, ethylene-butene copolymer, ethylene-octene copolymer, ethylene-vinyl acetate copolymer, polyvinyl chloride, and vinyl chloride.

29. The insulating layer according to claim 28, wherein weight ratios of components of the first compatibility layer (20) and the second compatibility layer (30) are the same or different.

30. The insulating layer according to any one of claims 19 to 29, wherein a total thickness of the support layer (10), the first compatibility layer (20), the second compatibility layer (30), the first bonding layer (40), and the second bonding layer (50) ranges from 20 µm to 200 µm.

31. The insulating layer according to claim 30, wherein a thickness ratio of the first bonding layer (40), the first compatibility layer (20), the support layer (10), the second compatibility layer (30), and the second bonding layer (50) ranges from 1:1:1:1:1 to 1:5:10:5:1.

32. A method for preparing an insulating layer, the preparation method being used for preparing the insulating layer according to any one of claims 19 to 31, and comprising:
performing blending, extracting, and pelletizing based on a weight ratio of material components of a first bonding layer (40), a first compatibility layer (20), a support layer (10), a second compatibility layer (30), and a second bonding layer (50); and
coextruding the five layers by cast film extrusion or blown film extrusion.

33. A back-contact conductive integrated back sheet, comprising the insulating layer according to any one of claims 1 to 31.

34. The back-contact conductive integrated back sheet according to claim 33, wherein a plurality of via holes are opened in the insulating layer, and the via holes are filled with a conductive material.

35. A photovoltaic module, comprising: a solar cell panel and the back-contact conductive integrated back sheet according to claim 33 or 34, wherein a circuit formed by a conductive material in via holes is interconnected with a circuit design of the solar cell panel.
